# EUROPÄISCHE PATENTANMELDUNG

(11) **EP 0 802 650 A2**
(43) Veröffentlichungstag der Anmeldung: **22.10.1997**
(21) Anmeldenummer: 97104733.7
(22) Anmeldetag: 20.03.1997
(51) Int. Cl.: H04L 7/04, H04L 7/10, H04L 1/00

(54) **Fehlerrobustes Multiplexverfahren**

(30) Priorität: 15.04.1996 DE 19614738; 08.05.1996 DE 19618386
(71) Anmelder: ROBERT BOSCH GMBH, 70442 Stuttgart (DE)
(72) Erfinder: Vogel, Peter, 31139 Hildesheim (DE); Wolf, Joachim, 31141 Hildesheim (DE); Lappe, Dirk, 31137 Schellerten/Dinklar (DE); Pelz, Rodolfo Mann, 30175 Hannover (DE); Nitche, Gunnar, 31139 Hildesheim (DE)

(57) **Zusammenfassung**

Es wird ein Verfahren zur Übertragung von Daten in einer Paketstruktur vorgeschlagen, daß zu einer deutlichen Reduktion von Übertragungsfehlern auf fehlerbehafteten Kanälen führt.

## Beschreibung

### Stand der Technik

Die Erfindung geht von einem Verfahren zur Übertragung von Datenblöcken nach der Gattung des Hauptanspruchs aus.

Es ist schon ein Verfahren zur Übertragung von Datenblöcke bekannt, das Protokoll H.22P (ITU-T Study Group 15, LBC 95-276 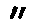 ITU-T Recommendation H.22P")
In diesem Protokoll werden die Rahmenstrukturen, die Formate der Daten- und Steuerfelder und eine Struktur für die vom Multiplexer zu übertragenden Daten, das Multiplexprotokoll, festgelegt. Das Multiplexprotokoll ermmöglicht die Verarbeitung von logischen Informationen, die über die Adaptationebene auf die Multiplexebene gelangen, in einheitliche Dateneinheiten. Das Protokoll ermöglicht die Übertragung von beliebigen Kombinationen von digitalen Audio und Videodaten oder anderen Informationen über eine Datenleitung und schlägt zur Verhinderung eines Datenverlustes ein spezielles Protokoll vor, das ein Synchronisationsmuster mit 31 Bits Länge aufweist. Ihm wird der HEADER (31 oder 63 bits) und das Informationsfeld mit fester Länge nachgestellt. Das Synchronisationsmuster muß durch eine Korrelationsbedingung im Empfänger erkannt werden, erst dann kann die Verarbeitung der Datenblöcke im Empfänger beginnen.
Bei diesem Verfahren können Datenverluste durch einen Verlust der Synchronisation auftreten. Zudem ist kein Mechanismus vorhanden, der Datenblöcke fester Länge mit Daten auffüllt, sollte die Datenquelle keine Daten mehr senden.

### Vorteile der Erfindung

Das erfindungsgemäße Verfahren mit den kennzeichnenden Merkmalen des Anspruch 1 hat demgegenüber den Vorteil, daß die Synchronisation mit einem Fehlererkennungsverfahren, das Fehler bei der Übertragung des HEADERs erkennt, kombiniert wird. Dadurch kann ein fehlerfreier HEADER für die Sicherstellung der Synchronisation herangezogen werden.

Durch die in den Unteransprüchen aufgeführten Maßnahmen sind besonders vorteilhafte Weiterbildungen und Verbesserungen des im Anspruch 1 angegebenen Verfahrens möglich.

Besonders vorteilhaft ist der Vorgang der Startsynchronisation, die eine sehr schnelle Möglichkeit zur Synchronisation aufzeigen.

Vorteilhafterweise wird die Startsynchronisation zur Sicherheit noch mehrfach durchgeführt.

Bei mehrfacher Synchronisation ist es sinnvoll nach Anspruch 5 auch einen Grenzwert zu definieren.

Wichtig für die Sicherheit des Verfahrens ist, daß das SYNC von einer Korrelationsfunktion erkannt wird.

Der schnelle Aufbau der Verbindung und eine gelungene Startsynchronisation sind erst durch das Fehlererkennungsverfahren gewärleistet.

Vorteilhaft für die problemlose Datenübertragung ist es, fehlende Informationen der Datenquelle durch Füllinformationen zu ersetzen.

Dazu ist es von Vorteil, das Feld INFORMATION mit Füllinformationen aufzufüllen, wenn die Datenquelle noch einen kompletten Rahmen gesendet hat.

Ist das nicht der Fall werden die Daten zwischengespeichert.

Eine sehr gute Möglichkeit der Auffüllung der Daten besteht in der Einspeisung von Synchronisationsworten der Datenquelle durch den Multiplexer.

Sehr günstig wirkt sich die Signalisierung, daß Füllbits verwendet wurden, im HEADER aus.

Eine weitere Verbesserung der Datensicherheit ist durch Verwendung von Softbits möglich.

Vorteilhaft für die sichere Übertragung ist auch die Ausführungsform, die Fehlererkennungs und Fehlerkorrekturverfahren auf den gesamten Datenblock erstreckt.

Eine weitere gute Möglichkeit ein fehlerrobustes Verfahren zu erhalten ist die Verteilung des HEADERs über den gesamten Datenblock (Interleaving).

### Zeichnung

Ein Ausführungsbeispiel des Erfindung ist in der Zeichnung dargestellt und wird in nachfolgender Beschreibung näher erläutert.
Es zeigen:
- Fig 1:: Struktur der Datenebenen für die Multiplexdatenübertragung
- Fig. 2:: Aufbau der Datenneinheit des Multiplexprotokolls
- Fig. 3:: Rahmenstruktur der Datenquellen

### Beschreibung des Ausführungsbeispiels

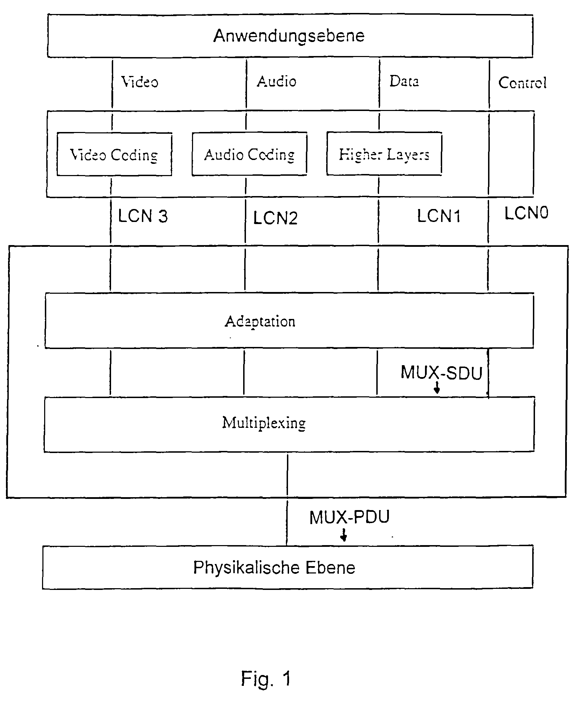

Die Datenübertragung von beliebigen Datensignalen findet nach Fig. 1 über hierarchisch gegliederte Ebenen statt. Von den einzelen Datengeräten kommen die zum Teil analogen Signale über die Anwendungsebene zur Kodierungsebene. Nach einem Digitalisierungsschritt werden die Inhalte der logischen Kanäle LCN an die Adaptationebene des Multiplexers weitergegeben. Immer noch in getrennten Kanälen werden die Daten als MUX-SDUs (Service Data Units) an die Multiplexebene weitergereicht. Diese Ebene verarbeitet die Vielzahl an Kanälen zu einem Kanal und gibt MUX-PDUs (Protocol Data Units) aus. Diese Datenblöcke werden nach dem erfindungsgemäßen Protokoll mit Signalen gefüllt.

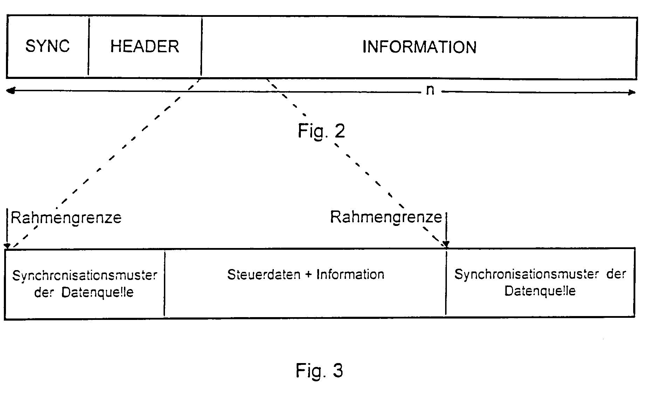

Fig. 2 zeigt eine solche MUX-PDU in der Abfolge der Steuer- und Datenfelder. Das erste Feld SYNC beeinhaltet ein Synchronisationsmuster variabler Länge, das eine klar zu detektierende Bitfolge von, z.B. 31 bit beinhaltet.
Das Synchronisationsmuster wird jedem Multiplexpaket vorangestellt. Als Muster können z. B. Barker- oder Williardsequenzen eingesetzt werden.
Im Feld HEADER legt man das Übertragungsschema für den nachfolgenden Informationsblock fest. Ein Beispiel für ein solches Übertragungsschema wird im Protokoll H.223 (ITU-T Study Group 15) beschrieben. Ein solcher HEADER weist z.B. 4 bits auf. Alle 16 Zustände, die der HEADER mit den 4 bits beschreiben kann, sind in einer Tabelle abgelegt. Möchte man z.B. nur Audiosignale übertragen, wird ein bestimmte Bitfolge gesetzt, wird der Informationsblock für Audio- und Videosignale geteilt wird eine andere Bitfolge gesendet. Im Anschluß folgt das Informationsfeld. Es ist nach den im HEADER festgelgten Regeln für die verschiedenen Datenquellen strukturiert. Das Informationsfeld wird so lange mit Daten gemäß des vom HEADER vorgegebenen Multiplexschema aufgefüllt, bis die Paketlänge n erreicht ist.
Als erster Schritt für eine Datenübertragung muß eine Verbindung aufgebaut werden. Dazu wird mit Hilfe eines Kontrollprotokolls die Länge n der Datenblöcke festgelegt. Die Länge n ist für Empfänger und Sender einstellbar, auch zu einem späteren Zeitpunkt. Dazu muß das Kontrollprotokoll in die Übertragung eingreifen und einen Abgleich vornehmen.

Da die Rahmenlänge n der Datenblöcke über einen im Kontrollprotokoll festgelegten Zeitraum konstant gehalten wird, läßt sich eine besonders einfache und fehlersichere Synchronisation erreichen, indem ein Synchronisationsmuster (SYNC) immer am Ende eines Datenblockes gesucht wird. Wenn jedoch nach dem Verbindungsaufbau fehlerhaft ein Synchronisationsmuster erkannt wird, so führt diese Synchronisationsstrategie dazu, daß ein nachfolgendes Synchronisationsmuster nicht erkannt werden kann, da es nicht im richtigen Zeitfenster liegt. Der Synchronisation des ersten Datenblockes, der Startsynchronistaion, kommt somit eine besondere Bedeutung zu und es muß sichergestellt werden, daß diese Startsyncchronisation mit besonderer Sicherheit erfolgt. Es wird für die Startsynchronisation vorgeschlagen, den HEADER mit in die Synchronisation einzubeziehen, d.h. eine Startsynchronisation kann nur erfolgen, wenn sowohl Synchronisationsmuster wie ein fehlerfreier HEADER gefunden werden. Für die Synchronisation der nachfolgenden Datenblöcke (MUX-PDUs) können dann eine gewisse Anzahl von fehlerhaften Synchronisationmuster oder HEADER akzeptiert werde, ohne daß deswegen die Synchronisation verloren geht.
Es ist beim Verbindungsaufbau und bei der Startsynchronisation z. B. von Vorteil, zu Beginn der Übertragung (Verbindungsaufbau mit Hilfe eines Kontrollprotokolls) kürzere Längen für n zu benutzen. Mit Hilfe des Kontrollprotokolls wird dann ein Zeitpunkt festgelegt, ab dem die Länge n geändert wird.

Zur Erkennung des SYNC auf der Empfängerseite der Datenübertragung im Demultiplexer wird eine Mindestanzahl von Bits festgelegt, die zwischen einem Muster im Datenstrom und dem vom Kontrollprotokoll festgelegten Synchronisationsmuster übereinstimmen müssen. Ist dieses Korrelationsminimum erreicht (Korrelationsbedingung), so gilt das Synchronisationsmuster als gefunden. Falls auf diese Weise ein Synchronisationsmuster gefunden wurde, läuft ein Fehlererkennungsverfahren für den HEADER ab. Eine erfolgreicher Aufbau der Synchronisation im Empfänger findet nur statt, wenn zum Synchronisationsmuster ein fehlerfreier HEADER gefunden wurde. Die Fehlererkennung kann im einfachsten Fall ein Parity-Check sein, wird aber vorzugsweise mit einem CRC-Code durchgeführt. Wurde ein Fehler bei der Übertragung der Daten entdeckt, wird das Synchronisationsverfahren mit der Suche nach dem nächsten Synchronisationsmuster fortgesetzt. In diesem Beispiel muß das SYNC und der dazugehörige fehlerfreie HEADER einmal gefunden werden, um die Startsynchronisation zuwege zu bringen.

Ist das Startsynchronisationsverfahren erfolgreich durchgeführt, wird das nächste Synchronisationsmuster jeweils nach einem kompletten Rahmen der Länge n gesucht. Gleichzeitig läuft ein Zähler mit, der inkrementiert wird, wenn das Synchronisationsmuster die Korrelationsbedingung nicht erfüllt und der HEADER nicht fehlerfrei erkannt werden kann. Hat der Zähler einen Grenzwert G2 (ganzzahliger Wert, der vom Kontrollprotokoll festgelegt wird) überschritten, gilt die Synchronisation als verloren und es muß nach obigem Schema neu synchronisiert werden. Typischerweise gilt die Synchronisation nach vier Versuchen als verloren und es erfolgt eine neue Startsynchronisation.
Ist die Synchronisation im Empfänger erfolgreich abgelaufen, beginnt die Verarbeitung des HEADERS und der INFORMATION.

### Weitere Ausführungsbeispiele:

Von Vorteil ist es, die Startsynchronisation sicherer gegen Fehler zu gestalten. Daher kann das Synchronisationsprinzip erweitert werden, indem das Synchronisationsmuster und der zugehörige fehlerfreie HEADER nicht nur einmalig, sondern G1-mal (ganze, einzustellende Zahl) gefunden werden muß, bevor die Synchronisation als erfolgreich gilt.

Eine weitere vorteilhafte Ausführungsform variiert die Startsynchronisation, indem für G1 aufeindanerfolgende Multiplexpakte das Synchronisationsmuster SYNC und für das letzte Paket ein feherfreier HEADER gefunden werden muß.

Eine weitere Ausführungsform findet im speziellem dann Anwendung, wenn in der Datenquelle nicht genügend Information vorhanden ist, um den zur Verfügung stehenden Platz im INFORMATION-Feld zu füllen.
Bei Verwendung konstanter Multiplexlängen n ist die einzufüllende Datenmenge in ein Multiplexpaket, der sogenannte Multiplex-Slot, für jede Datenquelle bekannt. Stellt eine Datenquelle ihre Datenübertragung ein, ist es sinnvoll den HEADER zu ändern und der Datenquelle somit im nächsten Informationsfeld keinen Platz mehr zur Verfügung zu stellen. Falls noch Restdaten der Datenquelle übertragen werden sollen, besteht die Möglichkeit, geeignete Füllbits zu verwenden und den Multiplex-Slot zu füllen. Dazu macht man sich die Rahmenstruktur der Datenströme in geeigneter Weise zu Nutze. Die Rahmenstruktur der Datenströme wird z. B. auf der Adaptationebene der Datenübertragung, siehe Fig.1, festgelegt.
Im speziellen Fall des Datenprotokolls H.324, das die Rahmenstruktur der Datenquellen vorgibt, kann folgendermaßen vorgegangen werden: Die Rahmenstruktur der Daten wird beispielsweise von Synchronisationsworten der Datenquelle begrenzt, siehe Fig. 3. Wie die Rahmenstruktur im einzelnen aussieht, wird im Protokoll H.245, H.263, G.723, sowie in Datenprotokollen festgelegt. An einer Rahmengrenze wird mindestens ein Synchronisationsmuster gesetzt. Die Steuerdaten enthalten z.B. Informationen über die Art der Datenquelle oder enthalten einen Fehlerschutz. Der Informationsblock enthält die eigentlich zu übertragenden Daten. Die Rahmenstruktur wird im Multiplexpaket, Fig. 1, in das INFORMATION-Feld eingespeist, d.h., daß sich mehrere Rahmen innerhalb des Feldes INFORMATION
befinden können.

Sollte eine Datenquelle zu wenig Daten geliefert haben, um den zugehörigen Multiplexslot im Feld INFORMATION komplett zu füllen, sind folgende Strategien möglich, um dennoch ein komplettes Multiplexpaket erstellen zu können:
a) Im ersten Fall geht man davon aus, daß die Datenquelle zwar Daten bis zu einem Rahmenende einspeist, daß aber das Feld INFORMATION des Datenblockes nicht mit Daten gefüllt wird. Die Datenquelle sendet Daten-Synchronisationswort und eventuell noch weitere Daten. Der Multiplexer füllt diese Daten-Synchronisationswort in den Multiplex-Slot ein. Nach der letzen gesendeten Rahmengrenze wird der Multiplexslot mit dem speziellen Synchronisationswort der Datenquelle aufgefüllt. Das Auffüllen mit Synchronisationsworten geschieht im Multiplexer selbst. Der Rest eines nicht komplett eingefüllten Synchronisationswortes sollte im nächsten Multiplexslot der entsprechenden Datenquelle eingefüllt werden.
b) Tritt der Fall ein, daß von der Datenquelle das Synchronisationswort zur Kennzeichnung der Rahmengrenze fehlt, muß man anders vorgehen. In diesem Fall muß der vorhandene Teil der Daten zwischengespeichert werden, bis die Datenquelle den Rest des Rahmens oder einen kompletten Multiplexslot an den Multiplexer geliefert hat. Es ist nicht möglich bei einem Abbruch des Datenstroms innerhalb des Feldes Information in Fig.3 ein Synchronisationswort einzufügen, da der Empfänger dieses Wort an dieser Stelle nicht fehlerfrei erkennen kann. Nach dem Speichervorgang wird der Multiplexslot mit Synchronisationsmustern der zugehörige Datenquelle vom Multiplexer gefüllt oder es wird ein anderer HEADER ausgewählt, der die betreffende Datenquelle nicht enthält.

Sollte nach dem obigen Verfahren zusätzliche Synchronisationsworte der Datenquelle eingefügt worden sein, ist es sinnvoll, diese mit einem zusätzlichen Bit HF im HEADER zu signalisieren.

Mit Hilfe des im HEADER zusätzlich eingefügte Bit HF kann ein weiterer Auffüllmecchanismus durchgeführt werden. Für jede Datenquelle, die gemäß Multiplex-Schema einen Multiplexslot im Datenblock reserviert hat, den sie nicht komplett füllen kann, wird fplgendes Schema angewandt:
a) das erste Byte des Multiplexslots auf 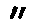 alles Null" (0000 0000) gesetzt wird, wenn der Rest des Multiplex-Slotes komplett mit Daten gefüllt werden kann.
b)Falls mehr als 1 Byte im Multiplexslot aufgefüllt werden muß, werden die entsprechenden Bytes mit 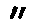 alles Eins" (1111 1111) gefüllt. Das letzte Byte vor Beginn der Daten wird immer auf 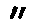 alles Null" gesetzt (gemäß a), z.B.

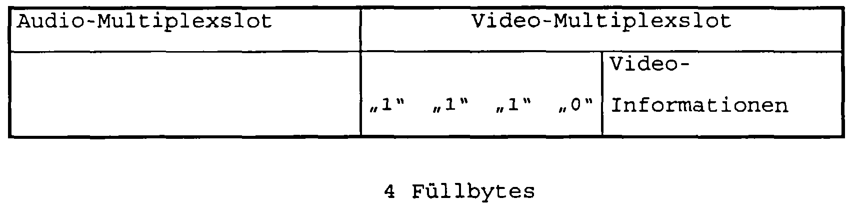

Erkennt der Empfänger mittels HF, daß sich Füllinformationen im Datenpaket befinden, so können diese unter Berücksichtigung der Füllregeln nach a) und b) entfernt werden. Treten allerdings pro Füllbyte mehr als 3 Übertragungsfehler auf, ist keine sichere Erkennung der Füllinformation mehr möglich.
Die Kennzeichnungen mit 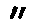 alles Null" und 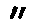 alles Eins" können in ihrer Bedeutung auch vertauscht vorliegen.
Es ist denkbar nur 7 der 8 Bits des Füllbytes auszuwerten, da bei Übertragungsfehlern das achte Bit sowieso redundant ist.

Ein weiter Möglichkeit besteht im Ersatz des einzelnen Bits HF durch t Bits. Mit t Bits läßt sich z.B. spezifizieren, für welche Datenquelle Füllbits benutzt wurden.

HF bsteht im nachfolgenden Beispiel aus 2 Bits. Mit diesen ist beispielsweise folgende Kodierung möglich:

| | |
|---|---|
| 00 | keine Füllinformation im Datenpaket |
| 01 | Füllinformation für Audio- oder Video-Quelle |
| 10 | Füllinformation für Data und Contol |
| 11 | Füllinformation für alle Quellen |

Das Füllverfahren mit den null- und einsgesetzten Bytes läßt sich auch anwenden, wenn im HEADER des Datenblocks kein Bit gesetzt wird, das Informationen über Füllbits trägt.
Es ist dann denkbar, daß im einem 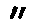 Zusatzheader" der Datenquelle die Information über die Füllbytes enthalten ist. Damit wäre der Vorgang des Auffüllens mit Füllbits vom HEADER des Multiplexers unabhängig. Die einzelnen Datenquellen besitzen dann über ihre eigenen Zusatzheader Informationen über eine mögliche Auffüllung mit Füllbits. Es ist auch möglich, daß die Zusatzheader vom Multiplexprotokoll in den Datenslots der Datenquellen definiert werden.

Zu einer zusätzlichen Verbesserung der Synchronisation in dem Multiplexer kann es sinnvoll sein, die sog. Softbits des Demodulators in dem Multiplexer weiterzuverarbeiten. Das bedeutet, daß Symbole anstelle von Bits weitergegeben werden. Gibt der Demultiplexer die Softbits an die Datenquelle weiter, können verbeserte FEC-Verfahren eingesetzt werden (Soft decision signal processing). Das Symbolformat schließt den Spezialfall der 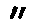 Hard decesion" ein, falls nur das MSB eines Symbols weiterverwendet wird.

Um das Multiplexschema möglichst sicher zu machen, sollte es zusammen mit einem fehlererkennenden Code (z. B. CRC) und anschließendem fehlerkorrigierenden Code (z. B. BCH, Reed-Solomon, RCPC) übertragen werden. Darüber hinaus ist es sinnvoll, den HEADER über das Multiplexpaket verteilt anzuordnen (Interleaving).

## Patentansprüche

1. Verfahren zur Datenübertragung mittels Datenblöcken zwischen zwei Stationen, wobei die Datenblöcke ein Synchronisationsmuster SYNC, einen HEADER und ein INFORMATIONS-Feld aufweisen, wobei das Synchronisationsmuster SYNC den Beginn des Datenblockes anzeigt und der HEADER Steuerzeichen für die Behandlung des nachfolgenden INFORMATIONS-Feldes enthält, dadurch gekennzeichnet, daß für die Startsynchronisation mindestens das Synchronisationsmuster SYNC und ein fehlerfreie HEADER gefunden werden muß.

2. Verfahren zur Datenübertragung mittels Datenblöcken zwischen zwei Stationen nach Anspruch 1 dadurch gekennzeichnet, daß als Startsynchronisation für mehrere aufeinanderfolgende Datenblöcke das Synchronisationsmuster SYNC und der fehlerfreie HEADER des letzten Datenblocks gefunden werden müssen

3. Verfahren zur Datenübertragung mittels Datenblöcken zwischen zwei Stationen nach Anspruch 1, dadurch gekennzeichnet, daß als Startsynchronisation zu einem Datenblock das Synchronisationsmuster SYNC und der dazugehörige fehlerfreie HEADER gefunden werden muß.

4. Verfahren zur Datenübertragung mittels Datenblöcken zwischen zwei Stationen nach Anspruch 1 und 2, dadurch gekennzeichnet, daß die Startsynchronisation G1-mal wiederholt wird.

5. Verfahren zur Datenübertragung mittels Datenblöcken zwischen zwei Stationen nach den Ansprüchen 1 und 2, dadurch gekennzeichnet, daß die Synchronisation als verloren gilt, wenn SYNC und der dazugehörige HEADER in einem Datenblock nicht gefunden werden können, oder wenn mehrfach bis zu einem Grenzwert G2 die Synchronisation nicht gelingt.

6. Verfahren zur Datenübertragung mittels Datenblöcken zwischen zwei Stationen nach den Ansprüchen 1 bis 5, dadurch gekennzeichnet, daß das Synchronisationsmuster SYNC über Korrelationsfunktionen erkannt werden muß.

7. Verfahren zur Datenübertragung mittels Datenblöcken zwischen zwei Stationen nach den Ansprüchen 1 bis 6, dadurch gekennzeichnet, daß zur Erkennung von Fehlern im HEADER Fehlererkennungsverfahren angewendet werden.

8. Verfahren zur Datenübertragung mittels Datenblöcken zwischen zwei Stationen, wobei die Datenblöcke ein Synchronisationsmuster SYNC, einen HEADER und einen INFORMATIONS-Feld aufweisen, wobei das Synchronisationsmuster SYNC den Beginn des Datenblockes anzeigt und der HEADER Steuerzeichen für die Behandlung des nachfolgenden INFORMATIONS-Feldes enthält, dadurch gekennzeichnet, daß das INFORMATIONS-Feld mit Füllinformationen aufgefüllt wird, wenn die sendende Datenquelle die eingestellte Länge des Datenblocks nicht mit Daten füllen kann.

9. Verfahren zur Datenübertragung mittels Datenblöcken zwischen zwei Stationen nach Anspruch 8, dadurch gekennzeichnet, daß nach einer vollständigen Erzeugung einer Rahmenstruktur der Datenquelle, der restliche Multiplexslot mit Füllinformation aufgefüllt wird, wenn die Datenquelle keine Daten mehr sendet.

10. Verfahren zur Datenübertragung mittels Datenblöcken zwischen zwei Stationen nach Anspruch 8, dadurch gekennzeichnet, daß nach einer nicht vollständigen Übertragung einer Rahmenstruktur der Datenquelle die Informationen zwischengespeichert wird und der Multiplexslot mit Füllinformation aufgefüllt wird oder ein anderer HEADER gewählt wird.

11. Verfahren zur Datenübertragung mittels Datenblöcken zwischen zwei Stationen nach den Ansprüchen 8 bis 10, dadurch gekennzeichnet, daß die Füllinformationen aus Synchronisationsworten der Datenquelle bestehen.

12. Verfahren zur Datenübertragung mittels Datenblöcken zwischen zwei Stationen nach den Ansprüchen 9 bis 11, dadurch gekennzeichnet, daß das Einfüllen von Füllinformationen im HEADER signalisiert wird.

13. Verfahren zur Datenübertragung mittels Datenblöcken zwischen zwei Stationen nach den Ansprüchen 9 bis 12, dadurch gekennzeichnet, daß das Einfüllen von Füllinformationen im HEADER mit t Bits signalisiert wird.

14. Verfahren zur Datenübertragung mittels Datenblöcken zwischen zwei Stationen nach den Ansprüchen 9 bis 13, dadurch gekennzeichnet, daß mit t Bits Datenquellen spezifiziert werden, für die die Füllinformationen benutzt werden.

15. Verfahren zur Datenübertragung mittels Datenblöcken zwischen zwei Stationen nach den Ansprüchen 8 bis 14, dadurch gekennzeichnet, daß die Füllinformationen aus mehreren aufeinanderfolgenden Bits besteht, vorzugsweise aus 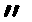 alles Null"(0000 0000) bzw. 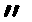 alles Eins" (1111 1111).

16. Verfahren zur Datenübertragung mittels Datenblöcken zwischen zwei Stationen nach den Ansprüchen 9 bis 15, dadurch gekennzeichnet, daß das Einfüllen von Füllinformationen im Zusatzheader der einzelen Quelle angezeigt wird.

17. Verfahren zur Datenübertragung mittels Datenblöcken zwischen zwei Stationen nach den Ansprüchen 1 bis 16, dadurch gekennzeichnet, daß im Demultiplexer 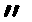 Softbits" weiterverarbeitet werden.

18. Verfahren zur Datenübertragung mittels Datenblöcken zwischen zwei Stationen nach den Ansprüchen 1 bis 17, dadurch gekennzeichnet, daß Fehlererkennungsverfahren und eventuell Fehlerkorrekturverfahren auf den gesamten Datenblock angewendet werden.

19. Verfahren zur Datenübertragung mittels Datenblöcken zwischen zwei Stationen nach den Ansprüchen 1 bis 18, dadurch gekennzeichnet, daß die Informationen des HEADERs über den gesamte Datenblock verteilt werden (Interleaving).
